# EUROPEAN PATENT APPLICATION

(11) **EP 4 827 258 A1**
(43) Date of publication of application: **21.10.2026**
(21) Application number: 26171527.0
(22) Date of filing: 09.04.2026
(51) Int. Cl.: H05K 7/20

(54) **PHOTOVOLTAIC INVERTER**

(30) Priority: 11.04.2025 CN 202520695332 U
(71) Applicant: HUAWEI TECHNOLOGIES CO., LTD., Shenzhen 518129 (CN)
(72) Inventor: CHEN, Yue, Shenzhen, 518129 (CN); LIU, Min, Shenzhen, 518129 (CN); ZHANG, Jiangteng, Shenzhen, 518129 (CN)
(74) Representative: Gill Jennings & Every LLP

(57) **Abstract**

This application provides a photovoltaic inverter. The photovoltaic inverter includes a housing, a circuit board, and a power conversion circuit. Internal space of the housing is separated into a plurality of accommodating cavities. The plurality of accommodating cavities include a first accommodating cavity. A switch transistor of the power conversion circuit is located in the first accommodating cavity, and an electronic component is disposed between the switch transistor and a terminal panel. At least one heat dissipation fin is disposed on an outer surface that is of a housing body and that is away from a cover body. Each heat dissipation fin extends in a direction perpendicular to the terminal panel, and is disposed opposite to the switch transistor. A height of the at least one heat dissipation fin in a direction perpendicular to the outer surface is constant. After the photovoltaic inverter is mounted, the heat dissipation fin is located between the housing body and a mounting surface. Therefore, when airflow flows along the heat dissipation fin, the airflow passes through the flat outer surface of the housing body without being blocked by the housing body, thereby improving heat dissipation effect.

## Description

### TECHNICAL FIELD

This application relates to the field of electronic technologies, and in particular, to a photovoltaic inverter.

### BACKGROUND

In a photovoltaic system, a photovoltaic inverter is configured to: convert a direct current generated by a photovoltaic module into an alternating current, and supply the alternating current to a power grid or a load. The photovoltaic inverter includes a housing and a circuit board located in the housing, and the circuit board is provided with a power conversion component and a switch component. When the photovoltaic inverter operates, the power conversion component and the switch component generate heat, and the heat is transferred to the outside of the photovoltaic inverter through the housing.

To improve heat dissipation efficiency of the photovoltaic inverter, a plurality of heat dissipation fins are usually disposed on an outer surface of a side that is of the housing and that is close to the component. However, because sizes of the power conversion component and the switch component are different, protrusions of different depths are formed on the foregoing outer surface of the housing. Therefore, heights and lengths of the plurality of heat dissipation fins arranged on the outer surface are also different, and consequently, heat dissipation areas of the heat dissipation fins are not uniform. As a result, heat dissipation efficiency of the photovoltaic inverter is affected.

### SUMMARY

This application provides a photovoltaic inverter, to improve heat dissipation effect of the photovoltaic inverter with an inverted circuit structure.

According to a first aspect, this application provides a photovoltaic inverter. The photovoltaic inverter includes a housing, a circuit board, and a power conversion circuit, where the circuit board and the power conversion circuit are located in the housing. Specifically, the housing includes a cover body and a housing body, and the cover body covers the housing body. The circuit board is located between the cover body and the housing body, and a plane on which the circuit board is located is parallel to a surface that is of the housing body and that faces the cover body. The housing body or the cover body includes a terminal panel, and the terminal panel is provided with a direct current input terminal and an alternating current output terminal. The housing body is provided with a plurality of separation plates, and the foregoing plurality separation plates extend from the housing body to the circuit board, and separate space between the housing body and the circuit board into a plurality of accommodating cavities. The plurality of accommodating cavities include a first accommodating cavity. The power conversion circuit includes at least one switch transistor. The at least one switch transistor is located in the first accommodating cavity, and at least one electronic component is disposed between the at least one switch transistor and the terminal panel. At least one heat dissipation fin is disposed on an outer surface of a side that is of the housing body and that is away from the cover body. The at least one heat dissipation fin and the at least one switch transistor are oppositely located on two sides of the housing body, and the at least one heat dissipation fin extends in a direction perpendicular to the terminal panel. A height of the at least one heat dissipation fin in a direction perpendicular to the outer surface is constant.

In this embodiment of this application, the photovoltaic inverter uses an inverted structure, to simplify a cable design of the power conversion circuit. Compared with a structure in which the power conversion circuit is disposed in the housing body in a forward direction (for example, a manner in which electronic components such as the switch transistor, an inductor, and a bus capacitor are disposed between the circuit board and the cover body), in the foregoing inverted structure, a distance between a heat emitting component and the housing body is shorter, that is, a heat transfer distance between the heat emitting component and the heat dissipation fin is shorter, and the housing body may directly transfer heat generated by the heat emitting component to the heat dissipation fin, and dissipate heat through the heat dissipation fin. This helps accelerate heat dissipation inside the photovoltaic inverter. The height of the heat dissipation fin is a size between an end part and a root part of the heat dissipation fin in the direction perpendicular to the outer surface. After the photovoltaic inverter is mounted on a mounting surface, the at least one heat dissipation fin is located between the outer surface of the housing body and the mounting surface, and space between the outer surface and the mounting surface is separated into a plurality of heat dissipation runners. These heat dissipation runners run through the entire photovoltaic inverter in a height direction of the photovoltaic inverter, and heat dissipation airflow passes through the heat dissipation runners without being blocked by the outer surface, thereby improving heat dissipation effect. In addition, the height of the heat dissipation fin is a constant value, so that a heat dissipation area of the at least one heat dissipation fin may be more uniform, thereby improving heat dissipation effect of the photovoltaic inverter with the inverted circuit structure.

In an embodiment, a projection of a part that is of each heat dissipation fin and that has the constant height overlaps the at least one switch transistor and the at least one electronic component. Therefore, both the switch transistor and a heat emitting electronic component between the switch transistor and the terminal panel dissipate heat through the heat dissipation fin with a uniform size, to further improve heat dissipation efficiency.

In an embodiment, the power conversion circuit further includes a first power inductor, a second power inductor, and a bus capacitor, and the at least one switch transistor includes a first switch transistor and a second switch transistor. The first power inductor, the first switch transistor, the bus capacitor, the second switch transistor, and the second power inductor are sequentially arranged in the first accommodating cavity in a direction parallel to a plane on which the terminal panel is located. The first power inductor is disposed opposite to the direct current input terminal, and the second power inductor is disposed opposite to the alternating current output terminal. The at least one heat dissipation fin includes at least one first heat dissipation fin and at least one second heat dissipation fin that are disposed in parallel. The at least one first heat dissipation fin is disposed opposite to the first switch transistor, and the at least one second heat dissipation fin is disposed opposite to the second switch transistor. In this embodiment, the first switch transistor may be a direct current side switch transistor, and the second switch transistor may be an alternating current side switch transistor. When the photovoltaic inverter operates, after entering from the direct current input terminal, a current passes through the first power inductor, the first switch transistor, the bus capacitor, the second switch transistor, and the second power inductor, and flows out from the alternating current output terminal, so that a current path that is approximately linear-shaped is formed at least on one side of the housing body. In this way, crossing of current paths can be reduced, thereby reducing impedance of the power conversion circuit.

In an embodiment, the plurality of accommodating cavities further include a second accommodating cavity and a third accommodating cavity. The first accommodating cavity, the second accommodating cavity, and the third accommodating cavity are separately disposed adjacent to the terminal panel. A part of the first accommodating cavity is located between the second accommodating cavity and the third accommodating cavity, and the other part of the first accommodating cavity is located on a side that is of the second accommodating cavity and the third accommodating cavity and that is away from the terminal panel. The power conversion circuit further includes a direct current side common-mode inductor, an inverter capacitor, and an alternating current side common-mode inductor. The direct current side common-mode inductor is located in the second accommodating cavity and is disposed adjacent to the direct current input terminal, and the alternating current side common-mode inductor is located in the third accommodating cavity and is disposed adjacent to the alternating current output terminal. The first power inductor is located on a side that is of the direct current side common-mode inductor and that is away from the direct current input terminal, the second power inductor is located on a side that is of the alternating current side inductor and that is away from the alternating current output terminal, and the inverter capacitor is located in the third accommodating cavity and located between the second power inductor and the alternating current side common-mode inductor. In this embodiment, a plurality of electronic components of the power conversion circuit are placed in different accommodating cavities, so that electromagnetic interference between the plurality of electronic components can be reduced, thereby improving electromagnetic compatibility of the photovoltaic inverter, reducing a loss of the photovoltaic inverter, and improving operating efficiency of the photovoltaic inverter. When the photovoltaic inverter operates, after entering from the direct current input terminal, a current sequentially passes through the direct current side common-mode inductor, the first power inductor, the first switch transistor, the bus capacitor, the second switch transistor, the second power inductor, the inverter capacitor, and the alternating current side common-mode inductor, and flows out from the alternating current output terminal, that is, sequentially flows along the second accommodating cavity, the first accommodating cavity, and the third accommodating cavity, thereby forming a current path that is approximately U-shaped in the housing body. In this way, crossing of current paths can be reduced, thereby reducing impedance of the power conversion circuit.

In an embodiment, the alternating current output terminal is a single-phase output terminal. The photovoltaic inverter in this embodiment may be a single-phase photovoltaic inverter. The power conversion circuit has a simple structure, and small electromagnetic interference can be implemented in limited space of the housing.

In an embodiment, a control component is further disposed in the second accommodating cavity, and the control component is configured to control the power conversion circuit. In this embodiment, the control component is located between the bus capacitor and the terminal panel. Therefore, when electrolyte leaks because the bus capacitor is faulty, because a circuit in which the control component is located is a weak-current circuit, damage to the power conversion circuit caused by the electrolyte entering a strong-current circuit can be avoided.

In an embodiment, a first thermal pad is disposed between the bus capacitor and a bottom wall that is of the housing body and that is in the second accommodating cavity; and/or a second thermal pad is disposed between the direct current side common-mode inductor and a bottom wall that is of the housing body and that is in the first accommodating cavity; and/or a third thermal pad is disposed between the alternating current side common-mode inductor and a bottom wall that is of the housing body and that is in the third accommodating cavity; and/or the power conversion circuit further includes a plurality of relays, the plurality of relays are located in the first accommodating cavity and located between the inverter capacitor and the alternating current side common-mode inductor, and a fourth thermal pad is disposed between the plurality of relays and the bottom wall that is of the housing body and that is in the first accommodating cavity. In this embodiment, the thermal pad may accelerate heat exchange between the component of the power conversion circuit and the housing body, thereby improving a heat dissipation rate and improving heat dissipation effect.

In an embodiment, a first boss and a second boss are disposed on the bottom wall that is of the housing body and that is in the first accommodating cavity, and the first boss and the second boss extend from the housing body towards the circuit board. The first boss separates the first power inductor from the bus capacitor, and the second boss separates the second power inductor from the bus capacitor. The first switch transistor is disposed on a surface that is of the first boss and that faces the circuit board, and the second switch transistor is disposed on a surface that is of the second boss and that faces the circuit board. In this embodiment, when the bus capacitor is faulty, electrolyte inside the bus capacitor may be ejected from the bus capacitor. The first boss and the second boss may separate the first power inductor and the second power inductor from the bus capacitor respectively, to prevent the power inductor from being damaged caused by the electrolyte entering the power inductor.

In an embodiment, at least one first electronic component is disposed between the first switch transistor and the terminal panel, and a height of the at least one first electronic component in a direction perpendicular to the circuit board is less than or equal to a sum of heights of the first switch transistor and the first boss in the direction perpendicular to the circuit board. At least one second electronic component is disposed between the second switch transistor and the terminal panel, and a height of the at least one second electronic component in the direction perpendicular to the circuit board is less than or equal to a sum of heights of the second switch transistor and the second boss in the direction perpendicular to the circuit board. In this way, on the outer surface of the side that is of the housing body and that is away from the cover body, a part that is of the outer surface and that is adjacent to the first switch transistor and the at least one first electronic component is a flat surface, and a part that is of the outer surface and that is adjacent to the second switch transistor and the at least one second electronic component is a flat surface, thereby ensuring that both heights of the first heat dissipation fin and the second heat dissipation fin are constant.

In an embodiment, a height of each first electronic component may be specifically less than or equal to 10 millimeters, and a height of each second electronic component may be specifically less than or equal to 10 millimeters.

### BRIEF DESCRIPTION OF DRAWINGS

FIG. 1 is a diagram of an application scenario of a photovoltaic system according to an embodiment of this application;
FIG. 2 is a diagram of a front view of a photovoltaic inverter according to an embodiment of this application;
FIG. 3 is a diagram of a rear view of a photovoltaic inverter according to an embodiment of this application;
FIG. 4 is an exploded diagram of a photovoltaic inverter according to an embodiment of this application;
FIG. 5 is a diagram of a housing body according to an embodiment of this application;
FIG. 6 is another diagram of a housing body according to an embodiment of this application;
FIG. 7 is a diagram of a layout of a housing body according to an embodiment of this application;
FIG. 8 is a sectional view of a housing body in FIG. 3 in an A-A direction;
FIG. 9 is a diagram of a current path when a photovoltaic inverter operates according to an embodiment of this application;
FIG. 10 is a sectional view of the housing body in FIG. 7 in a B-B direction; and
FIG. 11 is a top view of the housing body in FIG. 5 in a z direction.

### Reference numerals:

10-photovoltaic system; 11-photovoltaic module; 12-photovoltaic inverter;
13-energy storage device; 20-power grid; 31-switch transistor;
32-first power inductor; 33-second power inductor; 34-bus capacitor;
35: direct current side common-mode inductor; 36: inverter capacitor; 37: alternating current side common-mode inductor;
38-electronic component; 39-control component; 40-sampling circuit;
121-housing; 122-cover body; 123-housing body;
124-heat dissipation fin; 125-circuit board; 126-terminal panel;
127-direct current input terminal; 128-alternating current output terminal; 129-separation plates;
131-first accommodating cavity; 132-second accommodating cavity; 133-third accommodating cavity;
134-first boss; 135-second boss; 141-first heat dissipation fin;
142-second heat dissipation fin; 143-third heat dissipation fin; 311-first switch transistor; and
312-second switch transistor.

### DESCRIPTION OF EMBODIMENTS

To make the objectives, technical solutions, and advantages of this application clearer, the following further describes this application in detail with reference to the accompanying drawings.

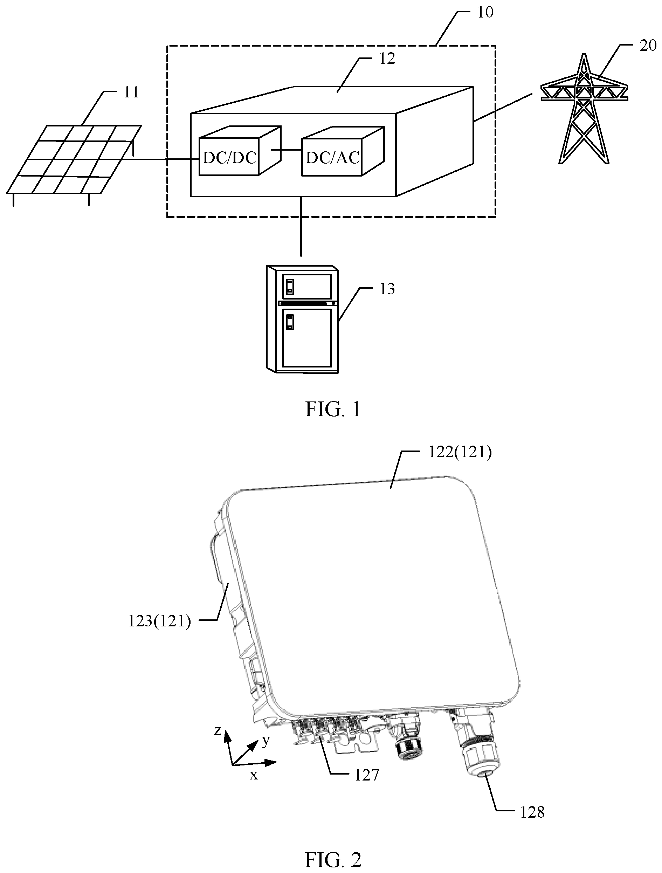

For ease of understanding a photovoltaic inverter provided in embodiments of this application, the following describes an application scenario of the photovoltaic inverter. The photovoltaic inverter in this application may be applied to a power supply system and a power generation system. A photovoltaic system is used as an example. The photovoltaic system may be used in two application scenarios: a home power plant and an industrial photovoltaic power plant. The photovoltaic inverter can convert solar energy into electric energy for a power grid or a load. FIG. 1 is a diagram of an application scenario of a photovoltaic system according to an embodiment of this application. As shown in FIG. 1, a photovoltaic system 10 is used in a home power plant. Specifically, a photovoltaic module 11 is configured to convert light energy into electric energy. The photovoltaic system 10 includes a photovoltaic inverter 12. One end of the photovoltaic inverter 12 is configured to connect to the photovoltaic module 11, and the other end is configured to connect to a power grid 20 or a load. The photovoltaic inverter 12 is configured to convert a direct current from the photovoltaic module 11 into an alternating current, and transfer the alternating current to the power grid 20 or the load. A photovoltaic optimizer may be further mounted in the photovoltaic system 10, and the photovoltaic optimizer may be configured to improve power generation efficiency of the photovoltaic module 11. The photovoltaic optimizer is a module-level power electronic component with a direct current input and a direct current output, is connected to the photovoltaic module 11 in series, uses a predictive current and voltage technology to ensure that the module keeps being in an optimal operating state, and according to an operating principle of a buck topology, is configured to resolve impact of shadow shading, inconsistent directions, or different module electrical specifications on an electric energy yield of a photovoltaic power station, so as to implement a maximum power output of the photovoltaic module 11 and improve an electric energy yield of the photovoltaic system 10. Certainly, the photovoltaic system 10 may further include an energy storage device 13. The alternating current converted by the photovoltaic inverter 12 may be further transferred to the energy storage device 13 for energy storage.

In addition, an on-grid/off-grid controller may be further disposed between the photovoltaic inverter 12 and the power grid 20. The photovoltaic inverter 12 may convert the direct current provided by the photovoltaic module 11 into the alternating current, and transfer the alternating current to the on-grid/off-grid controller. The on-grid/off-grid controller may also be electrically connected to an electric device. In an actual application scenario, the on-grid/off-grid controller has an off-grid state and an on-grid state. When the on-grid/off-grid controller is in the off-grid state, there is no electrical connection between the on-grid/off-grid controller and the power grid 20, and the alternating current transferred by the photovoltaic inverter 12 is provided only for the electric device. The electric device includes household appliances, for example, a television, an air conditioner, a refrigerator, and a washing machine.

When the on-grid/off-grid controller is in the on-grid state, the on-grid/off-grid controller is electrically connected to the power grid 20 by using a power sensor. When electric energy generated by the photovoltaic module 11 cannot meet a power consumption requirement of the electric device, the power grid 20 may supply electric energy to the photovoltaic system 10 by using the on-grid/off-grid controller. When an electric energy yield of the photovoltaic module 11 exceeds electricity used by the electric device, the on-grid/off-grid controller may transfer excess electricity to the power grid 20. The power sensor is configured to measure power flow between the photovoltaic system 10 and the power grid 20. For example, the power sensor may be an electricity meter.

As a loss requirement and an efficiency requirement of the photovoltaic system increase, a heat dissipation requirement of the photovoltaic inverter also gradually increases. Therefore, how to improve heat dissipation effect of the photovoltaic inverter gradually becomes an important research problem.

In view of this, this application provides a photovoltaic inverter, to improve heat dissipation effect of the photovoltaic inverter with an inverted circuit structure.

It should be noted that terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "one embodiment", "some embodiments", or the like described in this specification means that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

The terms "first", "second", and the like in this application are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, orientation terms such as "top", "bottom", "up", and "down" are defined relative to orientations of structures schematically placed in the accompanying drawings. It should be understood that these orientation terms are relative concepts used for relative description and clarification, and may correspondingly change based on changes in the orientations in which the structure are placed.

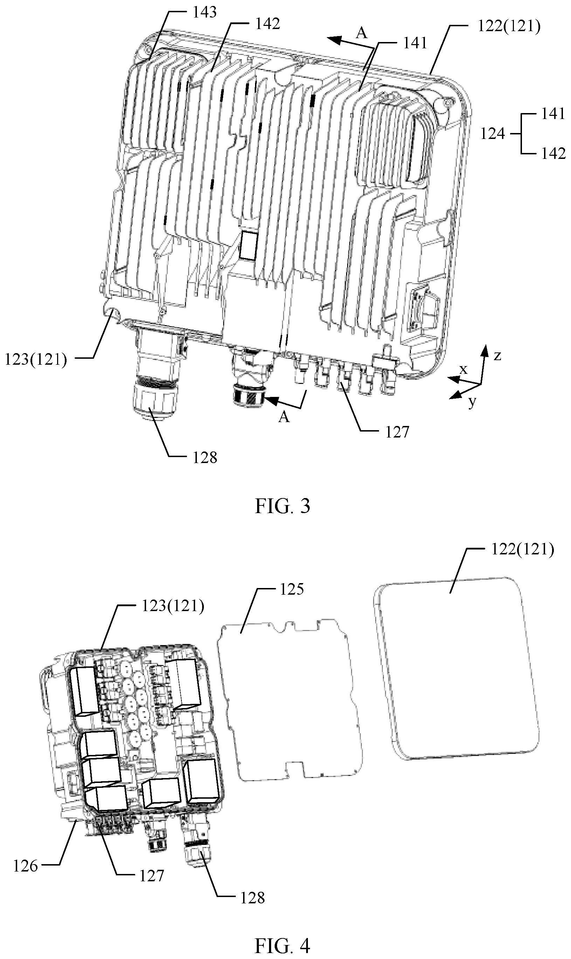

FIG. 2 is a diagram of a front view of the photovoltaic inverter according to an embodiment of this application. FIG. 3 is a diagram of a rear view of the photovoltaic inverter according to an embodiment of this application. As shown in FIG. 2 and FIG. 3, the photovoltaic inverter 12 includes a housing 121. The housing 121 includes a cover body 122 and a housing body 123. The cover body 122 is configured to cover the housing body 123, and accommodation space is formed between the cover body 122 and the housing body 123. In an actual application, a surface of a side that is of the housing body 123 and that is away from the cover body 122 is mounted on a mounting plate, and the cover body 122 faces a user. Therefore, an outer surface of the side that is of the housing body 123 and that is away from the cover body 122 is the rear of the photovoltaic inverter 12, and an outer surface of a side that is of the cover body 122 and that is away from the housing body 123 is the front of the photovoltaic inverter 12.

It should be noted that, in some embodiments, the housing body 123 may be of a pelvic structure, that is, the housing body 123 includes a bottom plate of the housing body and a plurality of side plates of the housing body, and the plurality of side plates of the housing body are sequentially connected and vertically connected to a periphery of the bottom plate of the housing body. In this embodiment, the cover body 122 may be of a plate structure, and is disposed opposite to the bottom plate of the housing body, and a periphery of the cover body 122 is connected to the foregoing plurality of side plates of the housing body. The cover body 122 may also be of a pelvic structure, that is, the cover body 122 includes a bottom plate of the cover body and a plurality of side plates of the cover body, and the plurality of side plates of the cover body are sequentially connected and vertically connected to a periphery of the bottom plate of the cover body. The bottom plate of the cover body is disposed opposite to the bottom plate of the housing body, and the foregoing plurality of side plates of the cover body are connected to the foregoing plurality of side plates of the housing body. In some other embodiments, the cover body 122 may be of a pelvic structure. The housing body 123 may be of a plate structure, and is disposed opposite to the bottom plate of the cover body. The housing body 123 is connected to a plurality of side plates of the cover body of the cover body 122. In some other embodiments, the housing body 123 may be of a pelvic structure, the cover body 122 may be of a plate structure, and the cover is connected to a plurality of side plates of the housing body of the housing body 123.

In addition, at least one heat dissipation fin 124 is disposed on an outer surface of a side that is of the housing body 123 and that is away from the cover body 122. Heat generated by an electronic component in the photovoltaic inverter 12 is transferred to the housing body 123, and heat is dissipated through the heat dissipation fin 124.

FIG. 4 is an exploded diagram of the photovoltaic inverter according to an embodiment of this application. As shown in FIG. 4, the photovoltaic inverter 12 further includes a circuit board 125 and a power conversion circuit, and the circuit board 125 and the power conversion circuit are located in the housing 121. Specifically, the circuit board 125 is located between the cover body 122 and the housing body 123, and a plane on which the circuit board 125 is located is parallel to a surface that is of the housing body 123 and that faces the cover body 122. The housing body 123 or the cover body 122 includes a terminal panel 126, and the terminal panel 126 is provided with a direct current input terminal 127 and an alternating current output terminal 128.

It should be noted that in this application, the terminal panel 126 is parallel to an x direction and a y direction, and is perpendicular to a z direction. The direct current input terminal 127 and the alternating current output terminal 128 are arranged on the terminal panel 126 in the x direction. The x direction is a width direction of the photovoltaic inverter 12, the y direction is a depth direction of the photovoltaic inverter 12, and the z direction is a height direction of the photovoltaic inverter 12.

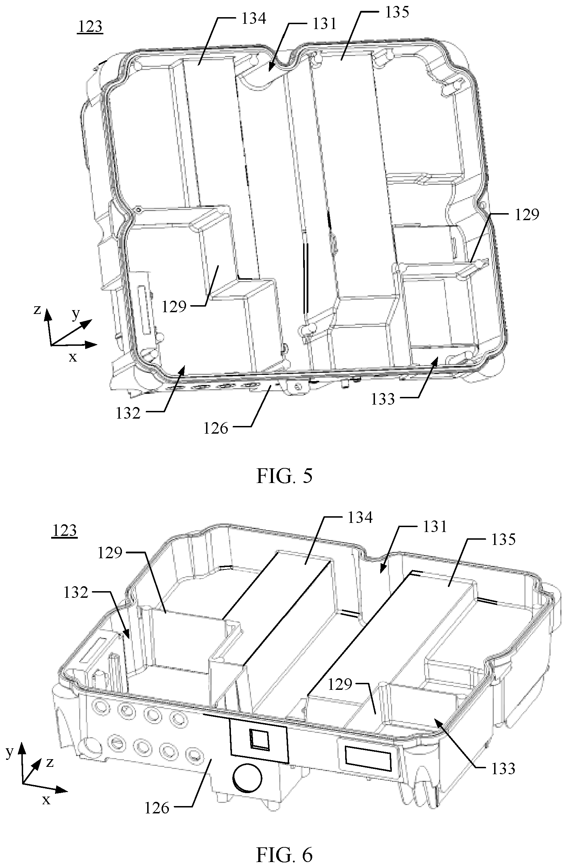

FIG. 5 is a diagram of the housing body according to an embodiment of this application, and FIG. 6 is another diagram of the housing body according to an embodiment of this application. As shown in FIG. 5 and FIG. 6, the housing body 123 is provided with a plurality of separation plates 129, and the foregoing plurality separation plates 129 extend from the housing body 123 to the circuit board 125, and separate space between the housing body 123 and the circuit board 125 into a plurality of accommodating cavities. The plurality of accommodating cavities include a first accommodating cavity 131, a second accommodating cavity 132, and a third accommodating cavity 133. The first accommodating cavity 131, the second accommodating cavity 132, and the third accommodating cavity 133 are separately disposed adjacent to the terminal panel 126. A part of the first accommodating cavity 131 is located between the second accommodating cavity 132 and the third accommodating cavity 133, and the other part of the first accommodating cavity 131 is located on a side that is of the second accommodating cavity 132 and the third accommodating cavity 133 and that is away from the terminal panel 126.

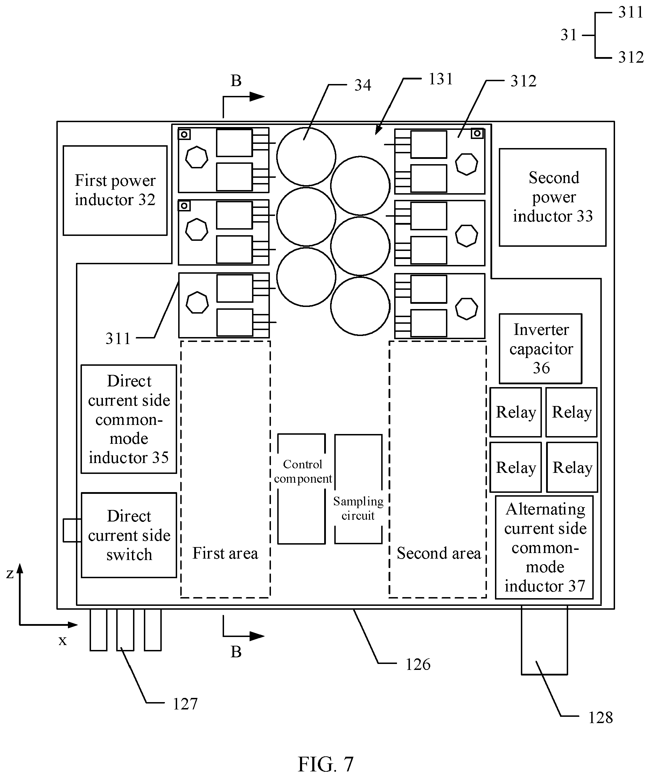

FIG. 7 is a diagram of a layout of the housing body according to an embodiment of this application. As shown in FIG. 7, the power conversion circuit includes at least one switch transistor 31. The at least one switch transistor 31 is located in the first accommodating cavity 131. In the first accommodating cavity 131, at least one electronic component is disposed between the switch transistor 31 and the terminal panel 126.

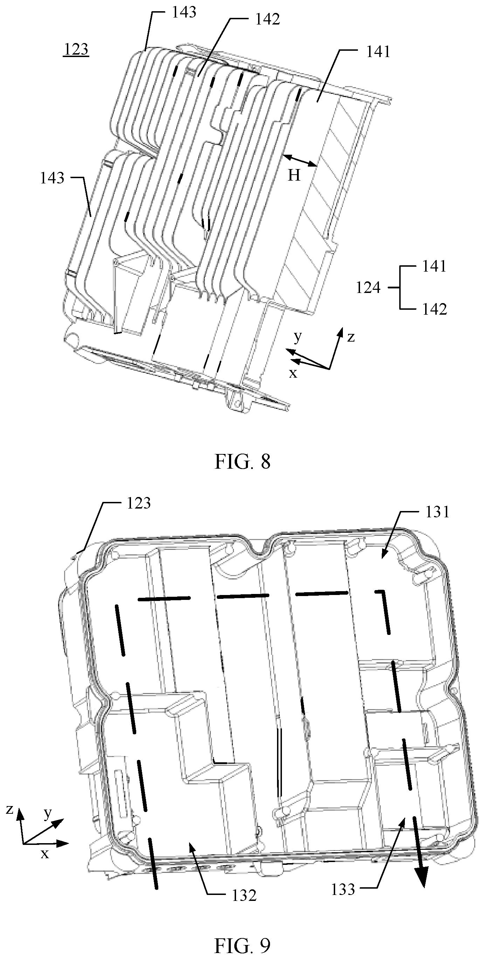

FIG. 8 is a sectional view of the housing body in FIG. 3 in an A-A direction. As shown in FIG. 7 and FIG. 8, the at least one heat dissipation fin 124 and the at least one switch transistor 31 in FIG. 7 are oppositely located on two sides of the housing body 123, and the at least one heat dissipation fin 124 extends in a direction perpendicular to the terminal panel 126. Each heat dissipation fin 124 has a projection perpendicular to the foregoing outer surface. In an extension direction of the heat dissipation fin 124, a height H of each heat dissipation fin 124 in a direction perpendicular to the outer surface is constant.

In this embodiment of this application, the photovoltaic inverter 12 uses an inverted structure, to simplify a cable design of the power conversion circuit. Compared with a structure in which the power conversion circuit is disposed in the housing body 123 in a forward direction (for example, a manner in which electronic components such as the switch transistor 31, an inductor, and a bus capacitor are disposed between the circuit board 125 and the cover body 122), in the foregoing inverted structure, a distance between a heat emitting component and the housing body 123 is shorter, that is, a heat transfer distance between the heat emitting component and the heat dissipation fin 124 is shorter, and the housing body 123 may directly transfer heat generated by the heat emitting component to the heat dissipation fin 124, and dissipate heat through the heat dissipation fin 124. This helps accelerate heat dissipation inside the photovoltaic inverter 12. After the photovoltaic inverter 12 is mounted, a heat dissipation runner between the outer surface of the housing body 123 and a mounting surface runs through the entire photovoltaic inverter 12 in a height direction of the photovoltaic inverter 12. Because a part that is of the outer surface and that is disposed with the heat dissipation fin 124 is a flat surface, airflow flowing along the heat dissipation fin 124 is not blocked by the housing body 123, thereby improving heat dissipation effect.

The height H of the heat dissipation fin 124 is a size of the heat dissipation fin 124 in the direction perpendicular to the outer surface, that is, a distance from an end part to a root part of the heat dissipation fin 124. Because a part that is of the heat dissipation fin 124 and whose projection is in the first accommodating cavity 131 has the constant height H, both the switch transistor 31 and a heat emitting electronic component between the switch transistor 31 and the terminal panel 126 dissipate heat through the at least one heat dissipation fin 124 of a same height, so that a heat dissipation area of the at least one heat dissipation fin 124 is more uniform, thereby improving heat dissipation efficiency of the photovoltaic inverter 12 with the inverted circuit structure.

In an embodiment, a projection of a part that is of each heat dissipation fin 124 and that has the constant height H overlaps the at least one switch transistor 31 and the at least one electronic component. Therefore, both the switch transistor 31 and the electronic component dissipate heat through the heat dissipation fin 124 with a uniform size, to further improve heat dissipation efficiency.

As shown in FIG. 7, the power conversion circuit further includes a first power inductor 32, a second power inductor 33, and a bus capacitor 34, and the at least one switch transistor 31 includes a first switch transistor 311 and a second switch transistor 312. The first power inductor 32, the first switch transistor 311, the bus capacitor 34, the second switch transistor 312, and the second power inductor 33 are sequentially arranged in the first accommodating cavity 131 in a direction parallel to a plane on which the terminal panel 126 is located. The first power inductor 32 is disposed opposite to the direct current input terminal 127, and the second power inductor 33 is disposed opposite to the alternating current output terminal 128.

The at least one heat dissipation fin 124 includes at least one first heat dissipation fin 141 and at least one second heat dissipation fin 142 that are disposed in parallel. The at least one first heat dissipation fin 141 is disposed opposite to the first switch transistor 311, and the at least one second heat dissipation fin 142 is disposed opposite to the second switch transistor 312. In this embodiment, the first switch transistor 311 may be a direct current side switch transistor, and the second switch transistor 312 may be an alternating current side switch transistor. When the photovoltaic inverter 12 operates, after entering from the direct current input terminal 127, a current passes through the first power inductor 32, the first switch transistor 311, the bus capacitor 34, the second switch transistor 312, and the second power inductor 33, and flows out from the alternating current output terminal 128, so that a current path that is approximately linear-shaped is formed at least on one side of the housing body 123. In this way, crossing of current paths can be reduced, thereby reducing impedance of the power conversion circuit.

Certainly, it may be understood that a plurality of third heat dissipation fins 143 may be disposed on the outer surface of the housing body 123, and these third heat dissipation fins 143 are distributed on two sides of the first heat dissipation fin 141 in the x direction and on two sides of the second heat dissipation fin 142 in the x direction.

Still refer to FIG. 7. The power conversion circuit further includes a direct current side common-mode inductor 35, an inverter capacitor 36, and an alternating current side common-mode inductor 37. The direct current side common-mode inductor 35 is disposed adjacent to the direct current input terminal 127, and the alternating current side common-mode inductor 37 is disposed adjacent to the alternating current output terminal 128. The first power inductor 32 is located on a side that is of the direct current side common-mode inductor 35 and that is away from the direct current input terminal 127, the second power inductor 33 is located on a side that is of the alternating current side inductor and that is away from the alternating current output terminal 128, and the inverter capacitor 36 is located between the second power inductor 33 and the alternating current side common-mode inductor 37. The direct current side common-mode inductor 35 is located in the first accommodating cavity 131. The inverter capacitor 36 and the alternating current side common-mode inductor 37 are located in the third accommodating cavity 133. In this embodiment, a plurality of electronic components of the power conversion circuit are placed in separated accommodating cavities, so that electromagnetic interference between the components can be reduced, thereby improving electromagnetic compatibility of the photovoltaic inverter 12, reducing a loss of the photovoltaic inverter 12, and improving operating efficiency of the photovoltaic inverter 12.

FIG. 9 is a diagram of a current path when the photovoltaic inverter operates according to an embodiment of this application. As shown in FIG. 7 and FIG. 9, when the photovoltaic inverter 12 operates, after entering from the direct current input terminal 127, a current sequentially passes through the direct current side common-mode inductor 35, the first power inductor 32, the first switch transistor 311, the bus capacitor 34, the second switch transistor 312, the second power inductor 33, the inverter capacitor 36, and the alternating current side common-mode inductor 37, and flows out from the alternating current output terminal 128, that is, sequentially flows along the second accommodating cavity 132, the first accommodating cavity 131, and the third accommodating cavity 133, thereby forming a current path that is approximately U-shaped in the housing body 123 (as shown by a dashed arrow in FIG. 9). In this way, crossing of current paths can be reduced, thereby reducing impedance of the power conversion circuit. In addition, the plurality of components are placed in the separated accommodating cavities, so that electromagnetic interference between the components can be reduced, thereby improving electromagnetic compatibility of the photovoltaic inverter 12, reducing a loss of the photovoltaic inverter 12, and improving operating efficiency of the photovoltaic inverter 12.

In some embodiments, the alternating current output terminal 128 is a single-phase output terminal. The photovoltaic inverter 12 in this embodiment may be a single-phase photovoltaic inverter. Compared with that of a three-phase photovoltaic inverter, the power conversion circuit of the single-phase photovoltaic inverter has a simple structure, and small electromagnetic interference can be implemented in limited space of the housing 121.

As shown in FIG. 5 and FIG. 6, in some embodiments, a first boss 134 and a second boss 135 are disposed on the bottom wall that is of the housing body 123 and that is in the first accommodating cavity 131, and the first boss 134 and the second boss 135 extend from the housing body 123 towards the circuit board 125. The first boss 134 separates the first power inductor 32 from the bus capacitor 34, and the second boss 135 separates the second power inductor 33 from the bus capacitor 34. The first switch transistor 311 is disposed on a surface that is of the first boss 134 and that faces the circuit board 125, and the second switch transistor 312 is disposed on a surface that is of the second boss 135 and that faces the circuit board 125. In this embodiment, when the bus capacitor 34 is faulty, electrolyte inside the bus capacitor 34 may be ejected from the bus capacitor 34. The first boss 134 and the second boss 135 may separate the first power inductor 32 and the second power inductor 33 from the bus capacitor 34 respectively, to prevent the power inductor from being damaged caused by the electrolyte entering the power inductor.

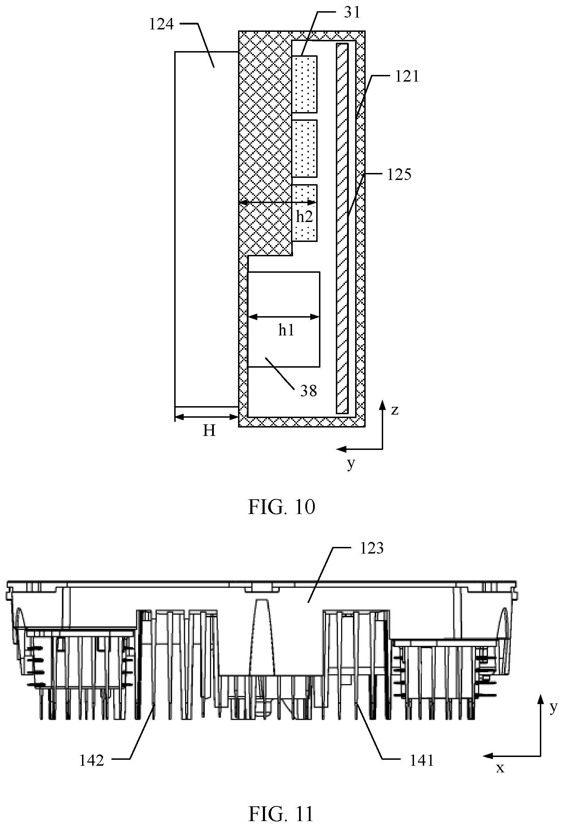

As shown in FIG. 7, at least one first electronic component may be disposed in a first area between the first switch transistor 311 and the terminal panel 126, and at least one second electronic component may be disposed in a second area between the second switch transistor 312 and the terminal panel 126. FIG. 10 is a sectional view of the housing body in FIG. 7 in a B-B direction, and FIG. 11 is a top view of the housing body in FIG. 5 in the z direction. As shown in FIG. 10 and FIG. 11, a height of the at least one first electronic component in a direction perpendicular to the circuit board 125 is less than or equal to a sum of heights of the first switch transistor 311 and the first boss 134 in the direction perpendicular to the circuit board 125, and a height of the at least one second electronic component in the direction perpendicular to the circuit board 125 is less than or equal to a sum of heights of the second switch transistor 312 and the second boss 135 in the direction perpendicular to the circuit board 125, as shown in FIG. 10. h1 is less than or equal to h2. In this way, on the outer surface of the side that is of the housing body 123 and that is away from the cover body 122, a part that is of the outer surface and that is adjacent to the first switch transistor 311 and the at least one first electronic component is a flat surface, and a part that is of the outer surface and that is adjacent to the second switch transistor 312 and the at least one second electronic component is a flat surface, so that flowing airflow is not blocked by the housing body 123.

In a specific embodiment, a height h of each first electronic component may be specifically less than or equal to 10 millimeters, and a height h of each second electronic component may be specifically less than or equal to 10 millimeters.

As shown in FIG. 7, a control component 39 and a sampling circuit 40 are further disposed in the second accommodating cavity 132, and the control component 39 is configured to control the power conversion circuit. In this embodiment, the control component 39 is located between the bus capacitor 34 and the terminal panel 126. Therefore, when electrolyte leaks because the bus capacitor 34 is faulty, because a circuit in which the control component 39 is located is a weak-current circuit, damage to the power conversion circuit caused by the electrolyte entering a strong-current circuit can be avoided.

In some embodiments, a first thermal pad is disposed between the bus capacitor 34 and a bottom wall that is of the housing body 123 and that is in the second accommodating cavity 132; and/or a second thermal pad is disposed between the direct current side common-mode inductor 35 and a bottom wall that is of the housing body 123 and that is in the first accommodating cavity 131; and/or a third thermal pad is disposed between the alternating current side common-mode inductor 37 and a bottom wall that is of the housing body 123 and that is in the third accommodating cavity 133; and/or the power conversion circuit further includes a plurality of relays, the relays are located in the first accommodating cavity 131 and located between the inverter capacitor 36 and the alternating current side common-mode inductor 37, and a fourth thermal pad is disposed between the plurality of relays and the bottom wall that is of the housing body 123 and that is in the first accommodating cavity 131. In this embodiment, the thermal pad may accelerate heat exchange between the component of the power conversion circuit and the housing body 123, thereby improving a heat dissipation rate and improving heat dissipation effect.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic inverter, comprising a housing, a circuit board, and a power conversion circuit, wherein the circuit board and the power conversion circuit are located in the housing;
the housing comprises a cover body and a housing body, wherein the cover body covers the housing body; the circuit board is located between the cover body and the housing body, and a plane on which the circuit board is located is parallel to a surface that is of the housing body and that faces the cover body; the housing body or the cover body comprises a terminal panel, and the terminal panel is provided with a direct current input terminal and an alternating current output terminal; and the housing body is provided with a plurality of separation plates, and the plurality of separation plates extend from the housing body towards the circuit board, and separate space between the housing body and the circuit board into a plurality of accommodating cavities, wherein the plurality of accommodating cavities comprise a first accommodating cavity; and
the power conversion circuit comprises at least one switch transistor; the at least one switch transistor is located in the first accommodating cavity, and at least one electronic component is disposed between the at least one switch transistor and the terminal panel; at least one heat dissipation fin is disposed on an outer surface of a side that is of the housing body and that is away from the cover body, the at least one heat dissipation fin and the at least one switch transistor are oppositely located on two sides of the housing body, and the at least one heat dissipation fin extends in a direction perpendicular to the terminal panel; and a height of the at least one heat dissipation fin in a direction perpendicular to the outer surface is constant.

2. The photovoltaic inverter according to claim 1, wherein a projection of a part having a constant height in each heat dissipation fin overlaps the at least one switch transistor and the at least one electronic component.

3. The photovoltaic inverter according to claim 1 or 2, wherein the power conversion circuit further comprises a first power inductor, a second power inductor, and a bus capacitor, and the at least one switch transistor comprises a first switch transistor and a second switch transistor; the first power inductor, the first switch transistor, the bus capacitor, the second switch transistor, and the second power inductor are sequentially arranged in the first accommodating cavity in a direction parallel to a plane on which the terminal panel is located; the first power inductor is disposed opposite to the direct current input terminal, and the second power inductor is disposed opposite to the alternating current output terminal; the at least one heat dissipation fin comprises at least one first heat dissipation fin and at least one second heat dissipation fin that are disposed in parallel; and the at least one first heat dissipation fin is disposed opposite to the first switch transistor, and the at least one second heat dissipation fin is disposed opposite to the second switch transistor.

4. The photovoltaic inverter according to claim 3, wherein the plurality of accommodating cavities further comprise a second accommodating cavity and a third accommodating cavity; the first accommodating cavity, the second accommodating cavity, and the third accommodating cavity are separately disposed adjacent to the terminal panel; and a part of the first accommodating cavity is located between the second accommodating cavity and the third accommodating cavity, and the other part of the first accommodating cavity is located on a side that is of the second accommodating cavity and the third accommodating cavity and that is away from the terminal panel; and
the power conversion circuit further comprises a direct current side common-mode inductor, an inverter capacitor, and an alternating current side common-mode inductor, wherein the direct current side common-mode inductor is located in the second accommodating cavity and is disposed adjacent to the direct current input terminal, and the alternating current side common-mode inductor is located in the third accommodating cavity and is disposed adjacent to the alternating current output terminal; and the first power inductor is located on a side that is of the direct current side common-mode inductor and that is away from the direct current input terminal, the second power inductor is located on a side that is of the alternating current side inductor and that is away from the alternating current output terminal, and the inverter capacitor is located in the third accommodating cavity and located between the second power inductor and the alternating current side common-mode inductor.

5. The photovoltaic inverter according to claim 4, wherein the alternating current output terminal is a single-phase output terminal.

6. The photovoltaic inverter according to claim 4 or 5, wherein a control component is further disposed in the second accommodating cavity, the control component is configured to control the power conversion circuit, and the control component is located between the bus capacitor and the terminal panel.

7. The photovoltaic inverter according to any one of claims 4 to 6, wherein a first thermal pad is disposed between the bus capacitor and a bottom wall that is of the housing body and that is in the second accommodating cavity; and/or
a second thermal pad is disposed between the direct current side common-mode inductor and a bottom wall that is of the housing body and that is in the first accommodating cavity; and/or
a third thermal pad is disposed between the alternating current side common-mode inductor and a bottom wall that is of the housing body and that is in the third accommodating cavity; and/or
the power conversion circuit further comprises a plurality of relays, the plurality of relays are located in the first accommodating cavity and located between the inverter capacitor and the alternating current side common-mode inductor, and a fourth thermal pad is disposed between the plurality of relays and the bottom wall that is of the housing body and that is in the first accommodating cavity.

8. The photovoltaic inverter according to any one of claims 3 to 7, wherein a first boss and a second boss are disposed on the bottom wall that is of the housing body and that is in the first accommodating cavity, and the first boss and the second boss extend from the housing body towards the circuit board; the first boss separates the first power inductor from the bus capacitor, and the second boss separates the second power inductor from the bus capacitor; and the first switch transistor is disposed on a surface that is of the first boss and that faces the circuit board, and the second switch transistor is disposed on a surface that is of the second boss and that faces the circuit board.

9. The photovoltaic inverter according to claim 8, wherein at least one first electronic component is disposed between the first switch transistor and the terminal panel, and a height of the at least one first electronic component in a direction perpendicular to the circuit board is less than or equal to a sum of heights of the first switch transistor and the first boss in the direction perpendicular to the circuit board; and
at least one second electronic component is disposed between the second switch transistor and the terminal panel, and a height of the at least one second electronic component in the direction perpendicular to the circuit board is less than or equal to a sum of heights of the second switch transistor and the second boss in the direction perpendicular to the circuit board.

10. The photovoltaic inverter according to claim 9, wherein both the height of the at least one first electronic component and the height of the at least one second electronic component are less than or equal to 10 millimeters.
